# EUROPEAN PATENT SPECIFICATION

(11) **EP 4 616 142 B1**
(45) Date of publication and mention of the grant of the patent: **12.08.2026**
(21) Application number: 23785816.2
(22) Date of filing: 10.10.2023
(51) Int. Cl.: G01B 11/00, G01D 5/38

(54) **POSITION MEASUREMENT SYSTEM AND LITHOGRAPHIC APPARATUS**
POSITIONSMESSSYSTEM UND LITHOGRAPHISCHE VORRICHTUNG
SYSTÈME DE MESURE DE POSITION ET APPAREIL LITHOGRAPHIQUE

(30) Priority: 10.11.2022 EP 22206565; 19.12.2022 EP 22214508
(43) Date of publication of application: 17.09.2025
(73) Proprietor: ASML Netherlands B.V., 5500 AH Veldhoven (NL)
(72) Inventor: JONES, Rachel Ann, 5500 AH Veldhoven (NL); BENTE, Erwin Antonius Josephus Maria, 5500 AH Veldhoven (NL)
(74) Representative: ASML Netherlands B.V.
(86) International application number: PCT/EP2023/077948
(87) International publication number: WO 2024/099660

(56) References cited:
- EP-B1- 2 857 802
- US-A1- 2007 058 173
- URA S ET AL: "INTEGRATED OPTIC HEAD FOR SENSING A TWO-DIMENSIONAL DISPLACEMENT OF A GRATING SCALE", APPLIED OPTICS, OPTICAL SOCIETY OF AMERICA, WASHINGTON, DC, US, vol. 35, no. 31, 1 November 1996 (1996-11-01), pages 6261 - 6266, XP000642054, ISSN: 0003-6935, DOI: 10.1364/AO.35.006261

## Description

### CROSS-REFERENCE TO RELATED APPLICATION

The application claims priority of EP application 22206565.8 filed on 10 November 2022 and EP application 22214508.8 filed on 19 December 2022.

### FIELD

The present invention relates to a position measurement system, lithographic apparatus, projection systems for optical lithography systems.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

In semiconductor manufacturing processes, multiple layers are provided on a substrate. Thereto, a pattern is projected onto the substrate, following which processing of the substrate with the projected pattern takes place. The process of projecting a pattern on the substrate and processing the projected pattern is repeated multiple times, e.g. using different patterns and/or different processing. In order to achieve small features on the substrate, the substrate is to be accurately positioned each time a pattern is projected onto the substrate, thereby to achieve that the successive patterns are accurately aligned with each other. The lithographic apparatus comprises a substrate table to hold the substrate. When projecting a pattern on the substrate, the substrate table may for example perform scanning movements, whereby parts of the substrate are successively irradiated. In order to accurately position the substrate, an accurate determination of the position of the substrate table is desired.

A position of the substrate table may be measured using one or more interferometers. Thereby, an optically reflective surface of the substrate table is irradiated by a measurement beam, which is reflected by the reflective surface, and interference measurements are performed. A Michelson interferometer may be applied. A position of the reflective surface, and hence a position of the substrate table, may be derived from the interference measurement.

In order to measure a position of the substrate table in multiple degrees of freedom, use may be made of a plurality of interferometers, for example to perform measurements in different directions. The measurements in different directions may involve interferometer beams which reflect at different parts of the substrate table, e.g. different sides of the substrate table. For example, in order to perform an X and a Y measurement in a horizontal plane, use may be made of dual interferometers each emitting an interferometer beam in mutually perpendicular directions and reflecting at mutually perpendicular surfaces of the substrate table. In order to accurately relate the measurements by the different interferometers to each other and to determine a position of the substrate table in a plurality of degrees of freedom therefrom, a rigid body behaviour of the substrate table may be desirable.

Requirements regarding a high throughput of the lithographic apparatus tend to require an increase of accelerations and speed of movement of the substrate table. In order to meet such high throughput requirements, a reduction of a mass of the substrate table is desirable. Such a reduction of mass of the substrate table may however adversely affect a rigid body behaviour of the substrate table, which may affect an accuracy of the position measurement of the substrate table.

Ura S et al.,"Integrated optic head for sensing a two-dimensional displacement of a grating scale", Appl Opt. 1996 Nov 1;35(31):6261-6 discloses a compact, two-dimensional integrated optic sensor built on a single planar chip that uses a waveguide and linearly focusing grating couplers to measure in-plane horizontal displacement.

### SUMMARY

Considering the above, it is an object of the invention to provide an accurate position measurement of an object which facilitates a weight reduction of the object.

According to an embodiment of the invention, there is provided an integrated displacement sensor comprising:
- a light guide configured to provide an optical path along a plane to guide a light source beam from a light source,
- an emission grating configured to receive at least a part of the light source beam and to diffract the light source beam in an emission direction away from the plane to form an emission beam,
- a target grating configured to be arranged on an object of interest to receive the emission beam, wherein the target grating is configured to diffract the emission beam to form a zero order diffraction beam, first order and minus first order diffraction beams;
- at least two first order couplers arranged in the plane and configured to receive the first order and minus first order diffraction beams and diffract the first order and minus first order diffraction beams into the plane to form planar first order and minus first order diffraction beams;
- a zero order coupler arranged in the plane and configured to receive the zero order diffraction beam and to diffract the zero order diffraction beam into the plane to form a planar zero order diffraction beam;
- a first order and minus first order combining device configured to receive the planar first order and minus first order diffraction beams and to generate at least one first diffraction order interference optical signal using the planar first order and minus first order diffraction beams;
- a zero order combining device configured to receive the planar zero order diffraction beam and a reference part of the light source beam and to generate a zero diffraction order interference optical signal using the planar zero order diffraction beam and the reference part of the light source beam;
- a first order optical sensor arranged to receive the at least one first diffraction order interference optical signal and to generate a first diffraction order output signal in response thereto;
- a zero order optical sensor arranged to receive the zero diffraction order interference optical signal and to generate a zero order output signal in response thereto.

According to a further embodiment of the invention, there is provided a position measurement system comprising one or more integrated displacement sensors according to the invention, anda processor configured to derive from the first order interference signal a position data of the object in a first direction parallel to the light guide plane, and to derive from the zero order interference signal a position data of the object in a direction perpendicular to the light guide plane.

According to a further embodiment of the invention, there is provided a lithographic apparatus comprising the position measurement system according to the present invention.

According to a further embodiment of the invention, there is provided a projection system for an optical lithography system comprising the position measurement system according to the present invention.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus according to an embodiment of the invention;
- Figure 2 depicts a detailed view of a part of the lithographic apparatus of Figure 1;
- Figure 3 schematically depicts a position control system as part of a positioning system according to an embodiment of the invention;
- Figure 4 schematically depicts a perspective view of a measurement system according to an embodiment of the present invention;
- Figure 5 schematically depicts a side view of the measurement system according to Figure 4;
- Figure 6 schematically depicts a top view of the measurement system according Figures 4 and 5;
- Figure 7 schematically depicts a top view of a measurement system according to another embodiment of the present invention; and
- Figure 8 schematically depicts a top view of a measurement system according to yet another embodiment of the present invention.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

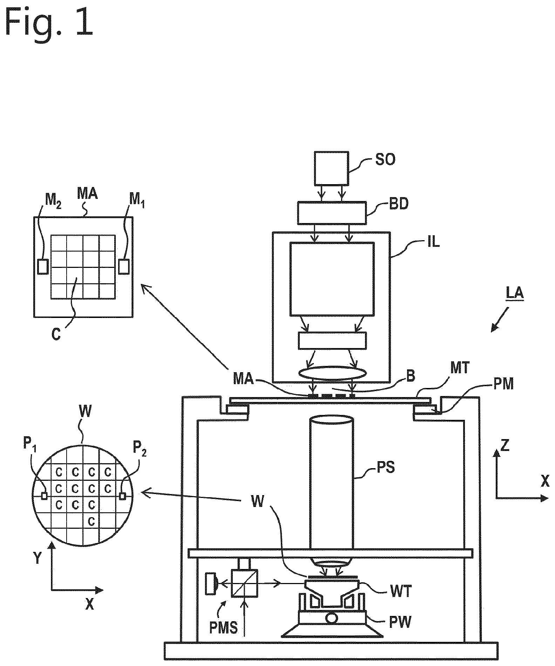

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the patterning device MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axes, i.e., an x-axis, a y-axis and a z-axis. Each of the three axes is orthogonal to the other two axes. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

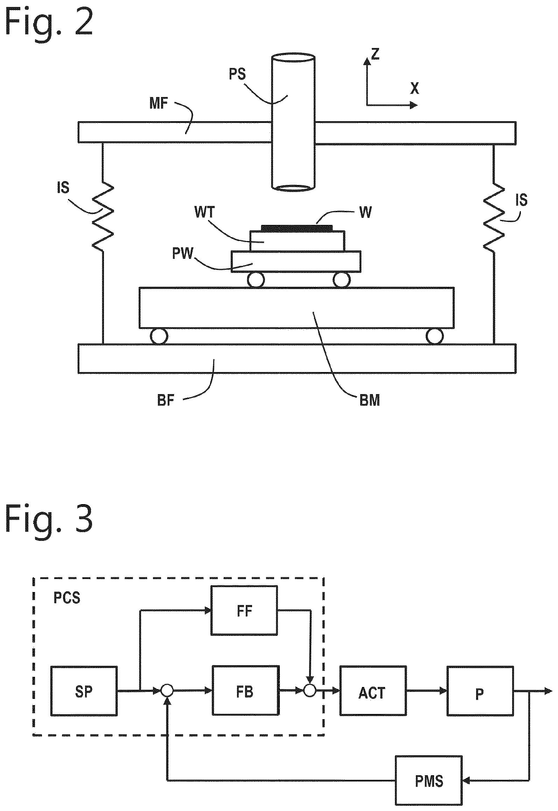

Figure 2 shows a more detailed view of a part of the lithographic apparatus LA of Figure 1. The lithographic apparatus LA may be provided with a base frame BF, a balance mass BM, a metrology frame MF and a vibration isolation system IS. The metrology frame MF supports the projection system PS. Additionally, the metrology frame MF may support a part of the position measurement system PMS. The metrology frame MF is supported by the base frame BF via the vibration isolation system IS. The vibration isolation system IS is arranged to prevent or reduce vibrations from propagating from the base frame BF to the metrology frame MF.

The second positioner PW is arranged to accelerate the substrate support WT by providing a driving force between the substrate support WT and the balance mass BM. The driving force accelerates the substrate support WT in a desired direction. Due to the conservation of momentum, the driving force is also applied to the balance mass BM with equal magnitude, but at a direction opposite to the desired direction. Typically, the mass of the balance mass BM is significantly larger than the masses of the moving part of the second positioner PW and the substrate support WT.

In an embodiment, the second positioner PW is supported by the balance mass BM. For example, wherein the second positioner PW comprises a planar motor to levitate the substrate support WT above the balance mass BM. In another embodiment, the second positioner PW is supported by the base frame BF. For example, wherein the second positioner PW comprises a linear motor and wherein the second positioner PW comprises a bearing, like a gas bearing, to levitate the substrate support WT above the base frame BF.

The position measurement system PMS may comprise any type of sensor that is suitable to determine a position of the substrate support WT. The position measurement system PMS may comprise any type of sensor that is suitable to determine a position of the mask support MT. The sensor may be an optical sensor such as an interferometer or an encoder. The position measurement system PMS may comprise a combined system of an interferometer and an encoder. The sensor may be another type of sensor, such as a magnetic sensor, a capacitive sensor or an inductive sensor. The position measurement system PMS may determine the position relative to a reference, for example the metrology frame MF or the projection system PS. The position measurement system PMS may determine the position of the substrate table WT and/or the mask support MT by measuring the position or by measuring a time derivative of the position, such as velocity or acceleration. Optionally, the position measurement system PMS may comprise any type of sensor that is suitable to determine a position of an optical element of the lithographic apparatus, in particular of a projection system for the lithographic apparatus.

The position measurement system PMS may comprise an encoder system. An encoder system is known from for example, United States patent application US2007/0058173A1, filed on September 7, 2006, hereby incorporated by reference. The encoder system comprises an encoder head, a grating and a sensor. The encoder system may receive a primary radiation beam and a secondary radiation beam. Both the primary radiation beam as well as the secondary radiation beam originate from the same radiation beam, i.e., the original radiation beam. At least one of the primary radiation beam and the secondary radiation beam is created by diffracting the original radiation beam with the grating. If both the primary radiation beam and the secondary radiation beam are created by diffracting the original radiation beam with the grating, the primary radiation beam needs to have a different diffraction order than the secondary radiation beam. Different diffraction orders are, for example, +1^{st} order, -1^{st} order, +2^{nd} order and -2^{nd} order. The encoder system optically combines the primary radiation beam and the secondary radiation beam into a combined radiation beam. A sensor in the encoder head determines a phase or phase difference of the combined radiation beam. The sensor generates a signal based on the phase or phase difference. The signal is representative of a position of the encoder head relative to the grating. One of the encoder head and the grating may be arranged on the substrate structure WT. The other of the encoder head and the grating may be arranged on the metrology frame MF or the base frame BF. For example, a plurality of encoder heads is arranged on the metrology frame MF, whereas a grating is arranged on a top surface of the substrate support WT. In another example, a grating is arranged on a bottom surface of the substrate support WT, and an encoder head is arranged below the substrate support WT.

The position measurement system PMS may comprise an interferometer system. An interferometer system is known from, for example, United States patent US6,020,964, filed on July 13, 1998, hereby incorporated by reference. The interferometer system may comprise a beam splitter, a mirror, a reference mirror and a sensor. A beam of radiation is split by the beam splitter into a reference beam and a measurement beam. The measurement beam propagates to the mirror and is reflected by the mirror back to the beam splitter. The reference beam propagates to the reference mirror and is reflected by the reference mirror back to the beam splitter. At the beam splitter, the measurement beam and the reference beam are combined into a combined radiation beam. The combined radiation beam is incident on the sensor. The sensor determines a phase or a frequency of the combined radiation beam. The sensor generates a signal based on the phase or the frequency. The signal is representative of a displacement of the mirror. In an embodiment, the mirror is connected to the substrate support WT. The reference mirror may be connected to the metrology frame MF. In an embodiment, the measurement beam and the reference beam are combined into a combined radiation beam by an additional optical component instead of the beam splitter.

The first positioner PM may comprise a long-stroke module and a short-stroke module. The short-stroke module is arranged to move the mask support MT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the first positioner PM is able to move the mask support MT relative to the projection system PS with a high accuracy over a large range of movement. Similarly, the second positioner PW may comprise a long-stroke module and a short-stroke module. The short-stroke module is arranged to move the substrate support WT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the second positioner PW is able to move the substrate support WT relative to the projection system PS with a high accuracy over a large range of movement.

The first positioner PM and the second positioner PW each are provided with an actuator to move respectively the mask support MT and the substrate support WT. The actuator may be a linear actuator to provide a driving force along a single axis, for example the y-axis. Multiple linear actuators may be applied to provide driving forces along multiple axis. The actuator may be a planar actuator to provide a driving force along multiple axis. For example, the planar actuator may be arranged to move the substrate support WT in 6 degrees of freedom. The actuator may be an electromagnetic actuator comprising at least one coil and at least one magnet. The actuator is arranged to move the at least one coil relative to the at least one magnet by applying an electrical current to the at least one coil. The actuator may be a moving-magnet type actuator, which has the at least one magnet coupled to the substrate support WT respectively to the mask support MT. The actuator may be a moving-coil type actuator which has the at least one coil coupled to the substrate support WT respectively to the mask support MT. The actuator may be a voice-coil actuator, a reluctance actuator, a Lorentz-actuator or a piezo-actuator, or any other suitable actuator.

The lithographic apparatus LA comprises a position control system PCS as schematically depicted in Figure 3. The position control system PCS comprises a setpoint generator SP, a feedforward controller FF and a feedback controller FB. The position control system PCS provides a drive signal to the actuator ACT. The actuator ACT may be the actuator of the first positioner PM or the second positioner PW. The actuator ACT drives the plant P, which may comprise the substrate support WT or the mask support MT. An output of the plant P is a position quantity such as position or velocity or acceleration. The position quantity is measured with the position measurement system PMS. The position measurement system PMS generates a signal, which is a position signal representative of the position quantity of the plant P. The setpoint generator SP generates a signal, which is a reference signal representative of a desired position quantity of the plant P. For example, the reference signal represents a desired trajectory of the substrate support WT. A difference between the reference signal and the position signal forms an input for the feedback controller FB. Based on the input, the feedback controller FB provides at least part of the drive signal for the actuator ACT. The reference signal may form an input for the feedforward controller FF. Based on the input, the feedforward controller FF provides at least part of the drive signal for the actuator ACT. The feedforward FF may make use of information about dynamical characteristics of the plant P, such as mass, stiffness, resonance modes and eigenfrequencies.

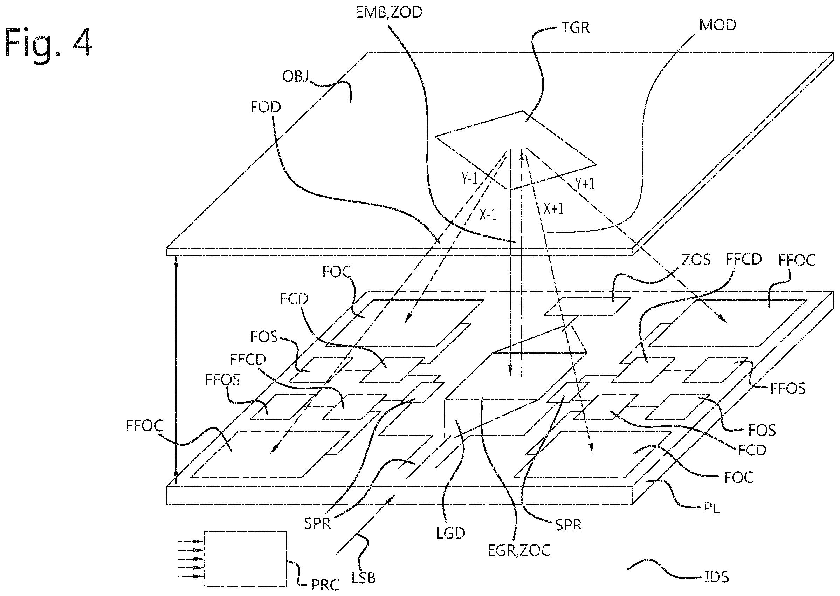

In Figures 4 - 8, the same or similar items are denoted by the same or similar reference symbols.

Figure 4 depicts a perspective view of a position measurement system PMS according to an embodiment of the present invention. The position measurement system comprises an integrated displacement sensor IDS to measure a position of an object OBJ, and a processor PRC.

The integrated displacement sensor IDS comprises the following parts, a majority of which are arranged in a plane PL of the integrated displacement sensor.

A light guide LGD provides an optical path along the plane to guide a light source beam LSB from a light source to an emission grating EGR.

The emission grating EGR receives at least a part of the light source beam from the light source and diffracts the light source beam in an emission direction away from the plane to form an emission beam EMB.

A target grating TGR is arranged to receive the emission beam EMB. The target grating is a reflection grating and may be arranged on the object OBJ, the position of which is to be determined. The target grating forms a diffraction grating to diffract the emission beam EMB to form a zero order diffraction beam ZOD, a first order diffraction beam FOD and a minus first order diffraction beam MOD. Higher order diffraction beams may also be formed. The zero order, first order and minus first order diffraction beams propagate back to the plane of the integrated displacement sensor IDS.

In the plane PL, couplers receive the zero order, first order and minus first order diffraction beams and diffract the respective beams into planar beams in directions parallel to the plane, as follows:

In the plane PL, two first order couplers FOC are arranged (positioned) to receive the first order diffraction beam and the minus first order diffraction beam. The first order couplers FOC comprise gratings which are arranged to diffract the first order and minus first order diffraction beams into the plane. The first order diffraction beam which is diffracted into the plane is identified as a planar first order diffraction beam. The minus first order diffraction beam which is diffracted into the plane is identified as a planar minus first order diffraction beam.

Similarly to the first order couplers, a zero order coupler ZOC is arranged in the plane to receive the zero order diffraction beam. The zero order coupler comprises a grating to diffract the zero order diffraction beam into the plane. The zero order diffraction beam diffracted into the plane is identified as a planar zero order diffraction beam.

The emission grating and the couplers may each comprise a Computer Generated hologram.

The light source beam may be split by one or more splitters SPR. In the present example, a first splitter SPR splits the light source beam into a part which is guided to the emission grating, and two parts which are each guided to respective further splitters SPR to split the respective parts of the light source beam in two parts. In the embodiment as depicted in Figure 4, the emission grating also forms a splitter, in that the emission grating comprises a leaky grating, whereby part of the light source beam is diffracted towards the target grating, and part of the light source beam propagates in the plane of the emission grating. In the present document, the part of the light source beam that propagates to the emission grating may be identified as the light source beam. The parts of the light source beam split off by the splitter may also be identified as partitions of the light source beam.

The planar zero order beam is interfered with a part of the light source beam LSB which part remains in the planar surface due to leakage of the emission grating. The planar first order and minus first order diffraction beams are either interfered with each other or are each interfered with a respective part of the light source beam, provided by the at least one splitter. In the latter case, the dual interference beams obtained by the interference may be electronically combined, as explained in more detail further below. In general terms, the integrated displacement sensor comprises:

a first order and minus first order combining device FCD which receives the planar first order and minus first order diffraction beams and generates at least one first diffraction order interference optical signal therefrom, i.e. generates the first diffraction order interferometer optical signal using the planar first order and minus first order diffraction beams.

In general terms, the integrated displacement sensor further comprises a zero order combining device which receives the planar zero order diffraction beam and a reference part of the light source beam. The zero order combining device generates a zero diffraction order interference optical signal using the planar zero order diffraction beam and the reference part of the light source beam.

The first diffraction order interference optical signal and the zero diffraction order interference optical signal are provided to respective optical sensors to generate respective electrical output signals. Accordingly, the integrated displacement sensor IDS further comprises a first order optical sensor FOS which receives the at least one first diffraction order interference optical signal and which generates a first diffraction order output signal (in the electrical domain) in response thereto. Similarly, the integrated displacement sensor IDS further comprises a zero order optical sensor ZOS arranged to receive the zero diffraction order interference optical signal and to generate a zero order output signal (in the electrical domain) in response thereto.

The position measurement system further comprises the processor PRC, such as a microprocessor or controller. The processor derives from the first order interference signal position data of the object in a first direction parallel to the light guide plane, and derives from the zero order interference signal position data of the object in a direction perpendicular to the light guide plane. The zero order interference signal, first order interference signal are provided to the processor.

For determining the displacement in the horizontal direction, i.e. the direction parallel to the plane PL, first order and minus first order diffraction beams that are captured back into the integrated displacement sensor IDS by the first order couplers may be combined in one of two ways: first order and minus first order diffraction beams may be combined together, alternatively each of the first order and minus first order diffraction beams is combined with the output of a continuous wave laser. When combining of the first order and minus first order diffraction beams is carried out in accordance with the latter of these approaches, a proportion may be split from the light source beam by a splitter, alternatively the output of said continuous wave laser may be emitted from a separate (second) light source that has been coupled into or is in communication with the integrated displacement sensor.

The optical interference signal, i.e. the first diffraction order interference optical signal, arising from the combined first order and minus first order diffraction beams is then incident on a detector integrated on the integrated displacement sensor IDS, e.g. a photodiode, where it is converted to the electronic domain and a down converted beat frequency may be detected. The electronic beat signal of the waves of the first order and minus first order diffraction beams may then be combined in accordance with techniques which will be familiar to the person skilled in the art. The result may be a wave whose intensity of signal varies as a cosine of the function of the grating displacement in the X or Y direction and has a period A. A high displacement resolution is determined by the pitch of the grating.

For determining the displacement in a substantially vertical direction, i.e. a direction substantially perpendicular to the plane PL, the zero order diffraction beam ZOD reflected from the target grating TGR is directed back to the plane PL where it is interfered with a portion of the input light source beam (LSB), thereby forming a Mach Zehnder interferometer. The change in the frequency will be due to the variation in the target grating's position in the vertical direction. Measuring the phase one may determine the change in the displacement in the in-plane and out of plane directions (x and z).

A position of the object in two dimensions may be measured using a single, integrated displacement sensor.

The planar first order and minus first order diffraction beams may be interfered in various ways, two possible embodiments are identified in the below:

In an embodiment, the first order and minus first order combining device is configured to optically interfere the planar first order and minus first order diffraction beams to generate the at least one first diffraction order interference optical signal. One the one hand, this embodiment may enable to derive the displacement in the direction in the plane immediately from the optical interference signal. On the other hand, it requires that these planar first order diffraction beams are optically brought together by respective planar optical guides in the plane, which may impose layout restrictions on other gratings or combining devices in the plane.

In another embodiment, the first order and minus first order combining device is configured to optically interfere the planar first order diffraction beam with a further reference part of the light source beam and to interfere the minus first order diffraction beam with the further reference part of the light source beam to generate two first diffraction order interference optical signals, and wherein the first order optical sensor is configured to receive the two first diffraction order interference optical signals and to generate two first diffraction order output signals in the electrical domain in response thereto, the processor being configured to derive from the two first order interference signals the position data of the object in the first direction parallel to the light guide plane. By this embodiment, more flexibility in layout in the plane may be provided in that the planar first order diffraction beams are optically brought together by respective planar optical guides in the plane, which may impose layout restrictions on other gratings or combining devices in the plane.

In an embodiment, the processor is configured to derive the position data from a phase difference in the respective interference signal. As explained above, the interference signal may provide a wave whose intensity of signal varies as a cosine of the function of the grating displacement in the X or Y direction and has a period A. A high displacement resolution is determined by the pitch of the grating. Thus, phase information may be accurately translated into displacement information.

In an embodiment, the target grating comprises a first target grating part and a second target grating part, the first target grating part being configured to diffract the emission beam to form the zero order diffraction beam, the first order diffraction beam and the minus first order diffraction beam, the second target grating part being configured to diffract the emission beam to form the zero order diffraction beam, a further first order diffraction beam and a further minus first order diffraction beam. In the embodiment, the displacement sensor further comprises further couplers, a further first order combining device and further first order optical sensor, as follows:
- at least two further couplers FFOC arranged in the light guide plane and configured to receive the further first order and further minus first order diffraction beams and diffract the further first order and minus first order diffraction beams into the light guide plane to form further planar first order and minus first order diffraction beams;
- a further first order and minus first order combining device FFCD configured to receive the further planar first order and minus first order diffraction beams and to generate at least one further first diffraction order interference optical signal using the further planar first order and minus first order diffraction beams;
- a further first order optical sensor FFOS arranged to receive the at least one further first diffraction order interference optical signal and to generate a further first diffraction order output signal in response thereto. In the embodiment, the processor is further configured to derive from the further first order interference signal a position data of the object in a second direction parallel to the light guide plane, and perpendicular to the first direction.

The position in the second direction parallel to the light guide plane may be determined in a same way as the determination of the position in the first direction parallel to the light guide plane. Accordingly, a position may be determined in three, mutually perpendicular directions. The present development enables to provide a photonic integrated sensor that is capable of measuring the relative displacement between the surface and the target grating in three translational degrees of freedom. The sensor combines two types of optical interferometers: a Mach Zehnder interferometer, with an 'effective' Fabry Perot interferometer in one arm, to measure the out of plane displacements of the target grating, and an optical interferometric encoder, to measure the in plane displacements. In this way use is made of both the first order diffracted light and the reflected normal to the plane of target surface light generated when light is incident on a grating.

The use of photonic integrated devices is foreseen to miniaturize existing sensors in terms of size, weight, and power consumption and thus allow for onstage sensing opportunities. Through utilizing the reflected and diffracted beams one may interfere the change in position of a target grating in the x, y and z direction using one single illuminated point instead of the three needed by line-of-sight interferometers on three different planes. This may reduce a footprint and mass on the stage. Furthermore, placing the light source on stage may significantly reduce the standoff of the sensors which may lessen the requirement on the frequency stability of measurement light. To measure to an accuracy of 500pm with an imbalance of 5mm one would require a laser with frequency stability 20MHz, in case of a laser beam wavelength of 1550nm.

In an embodiment, the first and second target grating parts are arranged substantially perpendicular to each other, whereby the target grating parts are arranged in a same plane, however the structure of the grating, e.g. the grating lines of the gratings, are perpendicular. As a result, seen in the light guide plane, the first order and minus first order diffraction beams propagate in a direction perpendicular to the further first order and minus first order diffraction beams, as the target grating parts are perpendicular to each other. Accordingly, the first direction derived from the first order and minus first order diffraction beams and second direction derived from the further first order and minus first order diffraction beams are inherently perpendicular to each other.

For miniaturization, the light guide, emission grating, couplers, combining devices and optical sensors may be arranged on a dielectric or semiconductor substrate.

In order to facilitate orthogonal measurement directions, the emission grating is configured such that the emission direction is substantially perpendicular to the light guide plane.

The position measurement system further comprises a light source configured to emit the light source beam to the light guide. The light source beam as emitted by the light source may be a monochrome beam.

Further degrees of freedom of the object may be measured in that the position measurement system comprises at least two integrated displacement sensors, wherein the target gratings are arranged on the object. More specifically, the respective target gratings of the at least two integrated displacement sensors may be mutually spaced apart on the object, the processor being configured to determine the position of the object in six degrees of freedom. Using two of these integrated displacement sensors would then allow the measurement of the 3 rotational DoFs.

For example, using two such sensors one may determine the rotational degrees of freedom.
Rz may be determined from a quotient of (*yy*1*-yy*2) over (*xx*1-*xx*2)
Ry may be determined from a quotient of (*zz*1-*zz*2) over (*xx*1*-xx*2)
Ry may be determined from a quotient of (*zz*1*-zz*2) over (*yy*1*-yy*2)
wherein (*xx*1*, yy*1*, zz*1) and *(xx2, yy2, zz2)* are the measured position of integrated displacement sensor 1 and integrated displacement sensor 2.

In accordance with the above example, six degrees of freedom may be measured with two integrated displacement sensors. As a result of incorporating fewer sensors, namely one for three degrees of freedom and two for six degrees of freedom, the present position measurement system may reduce a footprint of sensors in terms of size, weight, and power consumption.

Using a plurality of integrated displacement sensors, it not only possible to determine a position in multiple degrees of freedom. Instead thereof, or in addition thereto, a non-rigid body behavior may be determined. For example, a non-rigid body behavior may be determined by providing at least two integrated displacement sensors, the respective target gratings of the at least two integrated displacement sensors are mutually spaced apart on the object, the processor being configured to determine a deformation of the object e.g. by comparing position measurements from the at least two integrated displacement sensors.

In an embodiment as depicted in Figure 4, the emission grating is the zero order coupler, enabling that the emission beam and zero order diffraction beam propagate perpendicularly to the plane, hence facilitating a derivation of the position in the direction perpendicular to the plane.

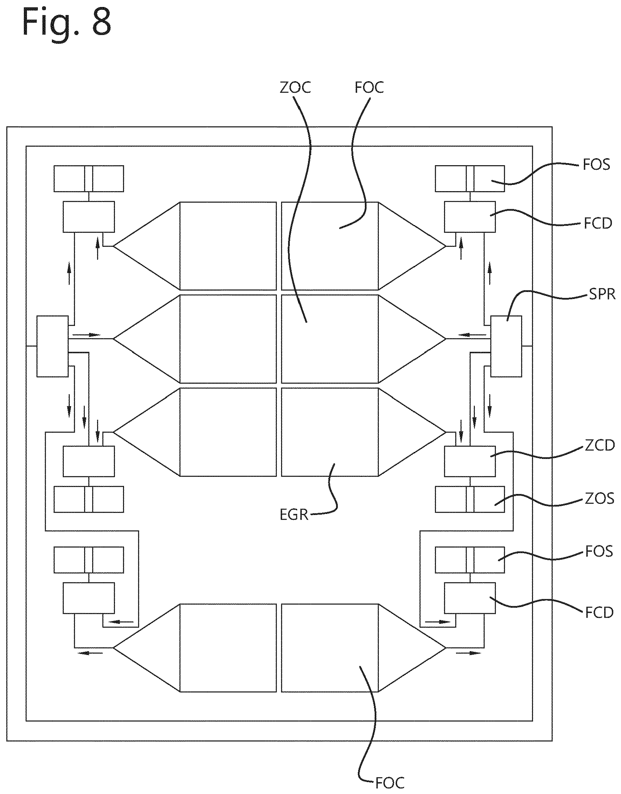

In an embodiment, as further described below with reference to Figure 8, two integrated displacement sensors may arranged on the plane, e.g. on a same chip, wherein the processor is further configured to derive from the position data of the object in the direction perpendicular to the light guide plane as derived for the two integrated displacement sensors a rotation of the object about the second direction parallel to the light guide plane, and perpendicular to the first direction.

As explained above, the position measurement system may be used to measure a position of an object of a lithographic apparatus. According to an aspect of the invention, there is provided a lithographic apparatus comprising the position measurement system as explained in the present document. The lithographic apparatus may comprise a substrate table configured to support a substrate, wherein the object comprises the substrate table. For example, the position measurement system may be configured to measure a position of a short stroke of the substrate table in respect of a long stroke of the substrate table. The at least one target grating of the at least one integrated displacement sensor may be arranged at the short stroke and the at least one remaining components of the at least one integrated displacement sensor may be arranged on the long stroke. Optionally, the object may be an optical element, for example a mirror or a lens, of the lithographic apparatus, in particular of a projection system for the lithographic apparatus.

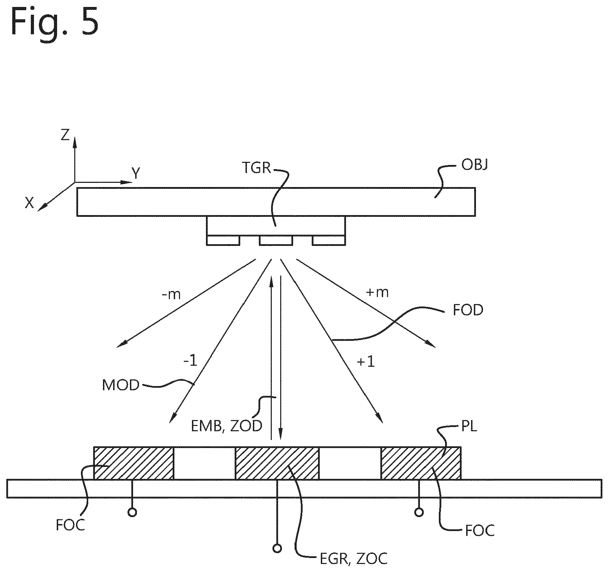

Figure 5 depicts a highly schematic, cross sectional side view of the integrated displacement sensor. Figure 5 depicts the object OBJ to which the target grating TRG is attached. The remainder of the integrated displacement sensor, the in-plane sensor, is depicted as PL, showing the emission grating EGR, the first and minus first order diffraction gratings FOG, MOG. The emission beam EMB from the emission grating is diffracted by the target grating to provide zero order diffraction beam ZOD, first order and minus first order diffraction beams FOD, MOD which are in turn diffracted by the first and minus first order diffraction gratings FOG, MOG as described above with reference to Figure 4.

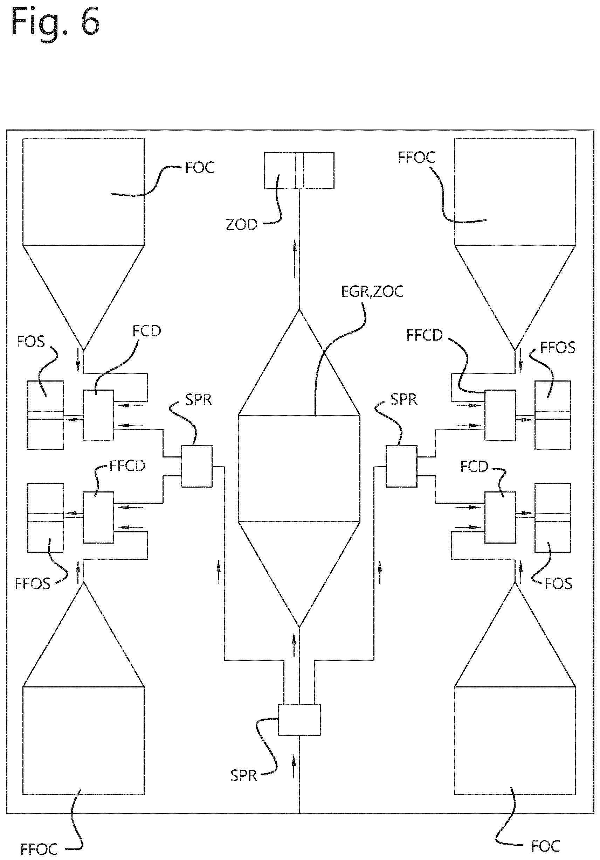

Figure 6 depicts a highly schematic top view of the integrated displacement sensor according to an embodiment of the present invention as described above with reference to Figures 4 and 5. The emission grating which also acts as the zero order coupler, the first order coupler and minus first order coupler, as well as the further first order coupler and further minus first order coupler have been described above. Likewise, the combining devices and optical sensors (photodetectors) have been described above. The light source beam is provided to the emission grating and to the combining devices as follows: The light source beam coupled into the integrated displacement sensor is first split into three proportions by an optical splitter SPR. A proportion of this light will go to the emission grating. A part of this proportion will be vertically diffracted by the emission grating, such as a Computer-Generated Hologram (CGH), towards the target grating (attached to the object whose position is to be measured) whilst another part of the proportion of the light will be transmitted though the weak emission grating to form a part of the light source beam for the zero order coupling device. The light reflected from target grating will be captured by the same emission grating (acting as the zero order coupler) and interfere with the light that was transmitted through it. The signal will be detected on the integrated displacement sensor by the photo detector. The other proportions of the light source beam as split by the optical splitter are guided to further optical splitters SPR to provide sub-proportions of the light source beam to each one of the first order combining device (X+ coupler), minus first order combining device (X- coupler), further first order combining device (Y+ coupler), and further minus first order combining device (Y- coupler). Thus, the other two proportions of the light coupled into the integrated displacement sensor are each split again in two and interfered using an optical combiner with one of the four first order diffractions (+Y, -Y, -X, +X) captured by the four CGH shown in the corner of the integrated displacement sensor. The interference patterns are detected on the integrated displacement sensor by a photodetector.

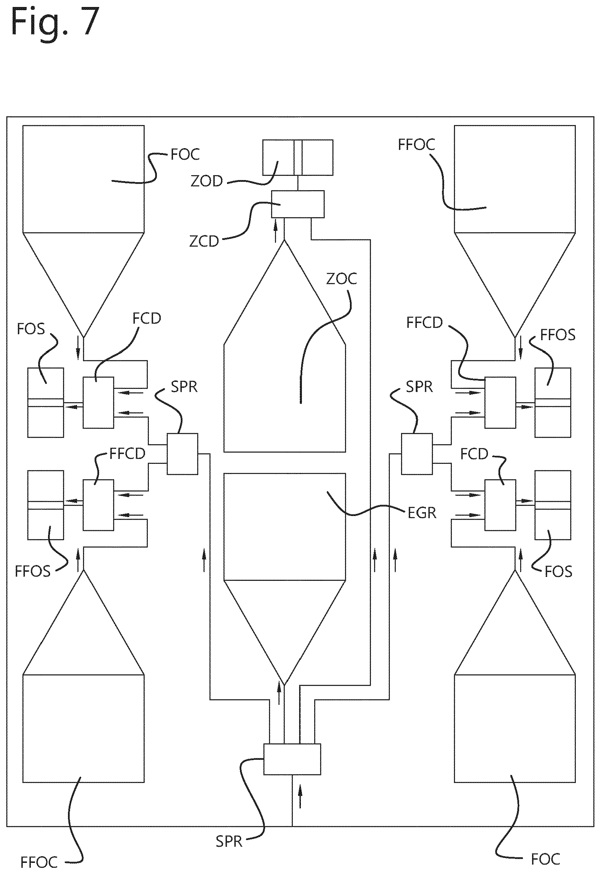

Fig. 7 depicts a highly schematic top view of an integrated displacement sensor according to an embodiment of the present invention. The integrated displacement sensor as depicted in Figure 7 largely corresponds to the integrated displacement sensor as depicted in Figure 6. However, the integrated displacement sensor according to the embodiment as depicted in Figure 7 comprises a separate emission grating EGR and zero order coupler ZOC grating instead of the combined emitter coupler.

The measurements in Figure 7 are similar to the measurement in the embodiment as shown in Figure 6. More specifically, the XY measurement remains the same, however the Z measurement has been changed. In Figure 7, the light source beam coupled into the integrated displacement sensor is split into four proportions. One proportion propagates to the emission grating, which diffracts the emission beam vertically toward the target grating, and the resulting reflected beam, i.e. the zero order diffraction beam is coupled into the integrated displacement sensor by a zero order coupler ZOC to form the planar zero order diffraction beam. Another proportion of the light source beam propagates through a waveguide. Said proportion of the light source beam and the planar zero order diffraction beam are combined using an optical combiner, the zero order combining device ZCD, and the interference signal detected on a photo diode, the zero order optical sensor ZOS.

Fig. 8 depicts a highly schematic top view of an integrated displacement sensor according to an embodiment of the present invention.

The configuration depicted in Figure 8 measures three degrees of freedom, the X, Z of two closely spaced illumination points and, through these two measurements, the rotation around the Y axis, Ry. The integrated displacement sensor has a line of symmetry in the plane of the drawing, one side will be explained below.

A light source beam from a light source is coupled into a waveguide of the integrated displacement sensor. This signal is split into four proportions. The z emitter will receive one proportion. This light passes a taper which increase the size of the mode and then is diffracted at an angle by the emission grating to form the emission beam, and the corresponding reflected zero order diffraction beam is collected by the zero order coupler to provide the planer zero order diffraction beam. The coupled planar zero order diffraction beam then passes through a taper to reduce the size of the mode to that of the waveguide and is then interfered with the proportion of the light source beam in the combiner. The resulting interference signal is then sent to the photo diode. The diffracted orders, i.e. the first order and minus first order diffraction beams captured by the first and minus first order couplers X- and X+ to form the planar first order and minus first order diffraction beams and similarly combined with one of the other two proportions of the light source beam. The respective arrangements at the left and the right part of Figure 8 hence both measure a position in X direction and in Z direction. The processor may derive the rotation about the y axis, Ry, from a quotient of *(zz1-zz2)* over *(xx1-xx2),* wherein zz1 and zz2 are the z measurements of the first and second sensor and xx1 and xx2 are the x measurements of the first and second sensor.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.
While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. An integrated displacement sensor (IDS) comprising:
- a light guide (LGD) configured to provide an optical path along a plane to guide a light source beam (LSB) from a light source,
- an emission grating (EGR) configured to receive at least a part of the light source beam (LSB) and to diffract the light source beam (LSB) in an emission direction away from the plane to form an emission beam (EMB),
- a target grating (TGR) configured to be arranged on an object (OBJ) of interest to receive the emission beam (EMB), wherein the target grating (TGR) is configured to diffract the emission beam (EMB) to form a zero order diffraction beam (ZOD), first order and minus first order diffraction beams (FOD, MOD); **characterised by**
- at least two first order couplers (FOC) arranged in the plane and configured to receive the first order and minus first order diffraction beams (FOD, MOD) and diffract the first order and minus first order diffraction beams (FOD, MOD) into the plane to form planar first order and minus first order diffraction beams;
- a zero order coupler (ZOC) arranged in the plane and configured to receive the zero order diffraction beam (ZOD) and to diffract the zero order diffraction beam (ZOD) into the plane to form a planar zero order diffraction beam;
- a first order and minus first order combining device (FCD) configured to receive the planar first order and minus first order diffraction beams and to generate at least one first diffraction order interference optical signal using the planar first order and minus first order diffraction beams;
- a zero order combining device configured to receive the planar zero order diffraction beam and a reference part of the light source beam (LSB) and to generate a zero diffraction order interference optical signal using the planar zero order diffraction beam and the reference part of the light source beam (LSB);
- a first order optical sensor (FOS) arranged to receive the at least one first diffraction order interference optical signal and to generate a first diffraction order output signal in response thereto;
- a zero order optical sensor (ZOS) arranged to receive the zero diffraction order interference optical signal and to generate a zero order output signal in response thereto.

2. A position measurement system (PMS) comprising one or more integrated displacement sensors (IDS) according to claim 1; and a processor (PRC) configured to derive from the first order interference signal a position data of the object (OBJ) in a first direction parallel to the light guide plane, and to derive from the zero order interference signal a position data of the object (OBJ) in a direction perpendicular to the light guide plane.

3. The position measurement system (PMS) according to claim 2, wherein the target grating (TGR) comprises a first target grating part and a second target grating part, the first target grating part being configured to diffract the emission beam (EMB) to form the zero order diffraction beam (ZOD), the first order diffraction beam and the minus first order diffraction beam (FOD, MOD), the second target grating part being configured to diffract the emission beam (EMB) to form the zero order diffraction beam (ZOD), a further first order diffraction beam and a further minus first order diffraction beam, and wherein the displacement sensor further comprises:
- at least two further couplers (FFOC) arranged in the light guide plane and configured to receive the further first order and further minus first order diffraction beams and diffract the further first order and minus first order diffraction beams into the light guide plane to form further planar first order and minus first order diffraction beams;
- a further first order and minus first order combining device (FFCD) configured to receive the further planar first order and minus first order diffraction beams and to generate at least one further first diffraction order interference optical signal using the further planar first order and minus first order diffraction beams;
- a further first order optical sensor (FFOS) arranged to receive the at least one further first diffraction order interference optical signal and to generate a further first diffraction order output signal in response thereto; and
wherein the processor (PRC) is configured to derive from the further first order interference signal a position data of the object (OBJ) in a second direction parallel to the light guide plane, and perpendicular to the first direction.

4. The position measurement system (PMS) according to claim 3, wherein the first and second target grating parts are arranged substantially perpendicularly to each other.

5. The position measurement system (PMS) according to any one claims 2-4, wherein the processor (PRC) is configured to derive the position data from a phase difference in the respective interference signal.

6. The position measurement system (PMS) according to any one of claims 2-5, wherein the first order and minus first order combining device (FCD) is configured to optically interfere the planar first order and minus first order diffraction beams to generate the at least one first diffraction order interference optical signal.

7. The position measurement system (PMS) according to any one claims 2-6, wherein the first order and minus first order combining device (FCD) is configured to optically interfere the planar first order diffraction beam with a further reference part of the light source beam (LSB) and to interfere the minus first order diffraction beam (MOD) with the further reference part of the light source beam (LSB) to generate two first diffraction order interference optical signals, and wherein the first order optical sensor (FOS) is configured to receive the two first diffraction order interference optical signals and to generate two first diffraction order output signals in response thereto, the processor (PRC) being configured to derive from the two first order interference signals the position data of the object (OBJ) in the first direction parallel to the light guide plane.

8. The position measurement system (PMS) according to any one of claims 2-7 further comprising a splitter configured to split off the reference part of the light source beam, and, when dependent on claim 7, the further reference part of the light source beam, from the light source beam (LSB).

9. The position measurement system (PMS) according to any one of claims 2-8, wherein the light guide (LGD), emission grating (EGR), couplers (ZOC, FOC, FFOC), combining devices (FCD, FFCD) and optical sensors (ZOS, FOS, FFOS) are arranged on a semiconductor substrate.

10. The position measurement system (PMS) according to any one of claims 2-9, wherein the emission grating (EGR) is configured such that the emission direction is substantially perpendicular to the light guide plane.

11. The position measurement system (PMS) according to any one of claims 2-10, further comprising the light source configured to emit the light source beam (LSB) to the light guide (LGD).

12. The position measurement system (PMS) according to any one of claims 2-11, comprising at least two integrated displacement sensors (IDS), wherein the target gratings (TGR) are arranged on the object.

13. The position measurement system (PMS) according to any one of claims 2-12, wherein the emission grating (EGR) is the zero order coupler (ZOC).

14. A lithographic apparatus (LA) comprising the position measurement system (PMS) according to any one of claims 2-13.

15. A projection system (PS) for an optical lithography system comprising the position measurement system (PMS) according to any one of claims 2-13.

## Patentansprüche

1. Ein integrierter Wegsensor (IDS), beinhaltend:
- einen Lichtleiter (LGD), der konfiguriert ist, um einen optischen Pfad entlang einer Ebene bereitzustellen, um einen Lichtquellenstrahl (LSB) von einer Lichtquelle zu leiten,
- ein Emissionsgitter (EGR), das konfiguriert ist, um mindestens einen Teil des Lichtquellenstrahls (LSB) zu empfangen und um den Lichtquellenstrahl (LSB) in einer von der Ebene weg gerichteten Emissionsrichtung zu beugen, um einen Emissionsstrahl (EMB) zu bilden,
- ein Zielgitter (TGR), das konfiguriert ist, um zum Empfangen des Emissionsstrahls (EMB) auf einem Objekt (OBJ) von Interesse angeordnet zu sein, wobei das Zielgitter (TGR) konfiguriert ist, um den Emissionsstrahl (EMB) zu beugen, um einen Beugungsstrahl nullter Ordnung (ZOD) und Beugungsstrahlen erster Ordnung und minus erster Ordnung (FOD, MOD) zu bilden; **gekennzeichnet durch**
- mindestens zwei Koppler erster Ordnung (FOC), die in der Ebene angeordnet sind und konfiguriert sind, um die Beugungsstrahlen erster Ordnung und minus erster Ordnung (FOD, MOD) zu empfangen und die Beugungsstrahlen erster Ordnung und minus erster Ordnung (FOD, MOD) in die Ebene zu beugen, um planare Beugungsstrahlen erster Ordnung und minus erster Ordnung zu bilden;
- einen Koppler nullter Ordnung (ZOC), der in der Ebene angeordnet ist und konfiguriert ist, um den Beugungsstrahl nullter Ordnung (ZOD) zu empfangen und um den Beugungsstrahl nullter Ordnung (ZOD) in die Ebene zu beugen, um einen planaren Beugungsstrahl nullter Ordnung zu bilden;
- eine die erste Ordnung und die minus erste Ordnung kombinierende Vorrichtung (FCD), die konfiguriert ist, um die planaren Beugungsstrahlen erster Ordnung und minus erster Ordnung zu empfangen und um unter Verwendung der planaren Beugungsstrahlen erster Ordnung und minus erster Ordnung mindestens ein optisches Interferenzsignal erster Beugungsordnung zu erzeugen;
- eine die nullte Ordnung kombinierende Vorrichtung, die konfiguriert ist, um den planaren Beugungsstrahl nullter Ordnung und einen Referenzteil des Lichtquellenstrahls (LSB) zu empfangen und um unter Verwendung des planaren Beugungsstrahls nullter Ordnung und des Referenzteils des Lichtquellenstrahls (LSB) ein optisches Interferenzsignal nullter Beugungsordnung zu erzeugen;
- einen optischen Sensor erster Ordnung (FOS), der angeordnet ist, um das mindestens eine optische Interferenzsignal erster Beugungsordnung zu empfangen und um als Reaktion darauf ein Ausgangssignal erster Beugungsordnung zu erzeugen;
- einen optischen Sensor nullter Ordnung (ZOS), der angeordnet ist, um das optische Interferenzsignal nullter Beugungsordnung zu empfangen und um als Reaktion darauf ein Ausgangssignal nullter Ordnung zu erzeugen.

2. Ein Positionsmesssystem (PMS), beinhaltend einen oder mehrere integrierte Wegsensoren (IDS) gemäß Anspruch 1; und einen Prozessor (PRC), der konfiguriert ist, um aus dem Interferenzsignal erster Ordnung Positionsdaten des Objekts (OBJ) in einer zu der Lichtleiterebene parallelen ersten Richtung abzuleiten und um aus dem Interferenzsignal nullter Ordnung Positionsdaten des Objekts (OBJ) in einer zu der Lichtleiterebene senkrechten Richtung abzuleiten.

3. Positionsmesssystem (PMS) gemäß Anspruch 2, wobei das Zielgitter (TGR) einen ersten Zielgitterteil und einen zweiten Zielgitterteil beinhaltet, wobei der erste Zielgitterteil konfiguriert ist, um den Emissionsstrahl (EMB) zum Bilden des Beugungsstrahls nullter Ordnung (ZOD) und des Beugungsstrahls erster Ordnung und des Beugungsstrahls minus erster Ordnung (FOD, MOD) zu beugen, wobei der zweite Zielgitterteil konfiguriert ist, um den Emissionsstrahl (EMB) zum Bilden des Beugungsstrahls nullter Ordnung (ZOD), eines weiteren Beugungsstrahls erster Ordnung und eines weiteren Beugungsstrahls minus erster Ordnung zu beugen, und wobei der Wegsensor ferner Folgendes beinhaltet:
- mindestens zwei weitere Koppler (FFOC), die in der Lichtleiterebene angeordnet sind und konfiguriert sind, um die weiteren Beugungsstrahlen erster Ordnung und minus erster Ordnung zu empfangen und die weiteren Beugungsstrahlen erster Ordnung und minus erster Ordnung in die Lichtleiterebene zu beugen, um weitere planare Beugungsstrahlen erster Ordnung und minus erster Ordnung zu bilden;
- eine weitere die erste Ordnung und die minus erste Ordnung kombinierende Vorrichtung (FFCD), die konfiguriert ist, um die weiteren planaren Beugungsstrahlen erster Ordnung und minus erster Ordnung zu empfangen und um unter Verwendung der weiteren planaren Beugungsstrahlen erster Ordnung und minus erster Ordnung mindestens ein weiteres optisches Interferenzsignal erster Beugungsordnung zu erzeugen;
- einen weiteren optischen Sensor erster Ordnung (FFOS), der angeordnet ist, um das mindestens eine weitere optische Interferenzsignal erster Beugungsordnung zu empfangen und um als Reaktion darauf ein weiteres Ausgangssignal erster Beugungsordnung zu erzeugen; und
wobei der Prozessor (PRC) konfiguriert ist, um aus dem weiteren Interferenzsignal erster Ordnung Positionsdaten des Objekts (OBJ) in einer zu der Lichtleiterebene parallelen und zu der ersten Richtung senkrechten zweiten Richtung abzuleiten.

4. Positionsmesssystem (PMS) gemäß Anspruch 3, wobei der erste und der zweite Zielgitterteil im Wesentlichen senkrecht zueinander angeordnet sind.

5. Positionsmesssystem (PMS) gemäß einem der Ansprüche 2-4, wobei der Prozessor (PRC) konfiguriert ist, um die Positionsdaten aus einer Phasendifferenz in dem jeweiligen Interferenzsignal abzuleiten.

6. Positionsmesssystem (PMS) gemäß einem der Ansprüche 2-5, wobei die die erste Ordnung und die minus erste Ordnung kombinierende Vorrichtung (FCD) konfiguriert ist, um die planaren Beugungsstrahlen erster Ordnung und minus erster Ordnung optisch interferieren zu lassen, um das mindestens eine optische Interferenzsignal erster Beugungsordnung zu erzeugen.

7. Positionsmesssystem (PMS) gemäß einem der Ansprüche 2-6, wobei die die erste Ordnung und die minus erste Ordnung kombinierende Vorrichtung (FCD) konfiguriert ist, um den planaren Beugungsstrahl erster Ordnung mit einem weiteren Referenzteil des Lichtquellenstrahls (LSB) optisch interferieren zu lassen und um den Beugungsstrahl minus erster Ordnung (MOD) mit dem weiteren Referenzteil des Lichtquellenstrahls (LSB) interferieren zu lassen, um zwei optische Interferenzsignale erster Beugungsordnung zu erzeugen, und wobei der optische Sensor erster Ordnung (FOS) konfiguriert ist, um die zwei optischen Interferenzsignale erster Beugungsordnung zu empfangen und um als Reaktion darauf zwei Ausgangssignale erster Beugungsordnung zu erzeugen, wobei der Prozessor (PRC) konfiguriert ist, um aus den zwei Interferenzsignalen erster Ordnung die Positionsdaten des Objekts (OBJ) in der zu der Lichtleiterebene parallelen ersten Richtung abzuleiten.

8. Positionsmesssystem (PMS) gemäß einem der Ansprüche 2-7, ferner beinhaltend einen Teiler, der konfiguriert ist, um den Referenzteil des Lichtquellenstrahls und, wenn von Anspruch 7 abhängig, den weiteren Referenzteil des Lichtquellenstrahls von dem Lichtquellenstrahl (LSB) abzuteilen.

9. Positionsmesssystem (PMS) gemäß einem der Ansprüche 2-8, wobei der Lichtleiter (LGD), das Emissionsgitter (EGR), die Koppler (ZOC, FOC, FFOC), die kombinierenden Vorrichtungen (FCD, FFCD) und die optischen Sensoren (ZOS, FOS, FFOS) auf einem Halbleitersubstrat angeordnet sind.

10. Positionsmesssystem (PMS) gemäß einem der Ansprüche 2-9, wobei das Emissionsgitter (EGR) so konfiguriert ist, dass die Emissionsrichtung im Wesentlichen senkrecht zu der Lichtleiterebene ist.

11. Positionsmesssystem (PMS) gemäß einem der Ansprüche 2-10, ferner beinhaltend die Lichtquelle, die konfiguriert ist, um den Lichtquellenstrahl (LSB) zu dem Lichtleiter (LGD) zu emittieren.

12. Positionsmesssystem (PMS) gemäß einem der Ansprüche 2-11, beinhaltend mindestens zwei integrierte Wegsensoren (IDS), wobei die Zielgitter (TGR) auf dem Objekt angeordnet sind.

13. Positionsmesssystem (PMS) gemäß einem der Ansprüche 2-12, wobei das Emissionsgitter (EGR) der Koppler nullter Ordnung (ZOC) ist.

14. Ein lithographisches Gerät (LA), beinhaltend das Positionsmesssystem (PMS) gemäß einem der Ansprüche 2-13.

15. Ein Projektionssystem (PS) für ein optisches Lithographiesystem, beinhaltend das Positionsmesssystem (PMS) gemäß einem der Ansprüche 2-13.

## Revendications

1. Un capteur de déplacement intégré (IDS) comprenant :
- un guide de lumière (LGD) configuré pour fournir un chemin optique le long d'un plan pour guider un faisceau de source de lumière (LSB) provenant d'une source de lumière,
- un réseau d'émission (EGR) configuré pour recevoir au moins une partie du faisceau de source de lumière (LSB) et pour diffracter le faisceau de source de lumière (LSB) dans une direction d'émission à l'écart du plan pour former un faisceau d'émission (EMB),
- un réseau cible (TGR) configuré pour être agencé sur un objet (OBJ) d'intérêt afin de recevoir le faisceau d'émission (EMB), le réseau cible (TGR) étant configuré pour diffracter le faisceau d'émission (EMB) afin de former un faisceau de diffraction d'ordre zéro (ZOD) et des faisceaux de diffraction d'ordre un et d'ordre moins un (FOD, MOD) ; **caractérisé par**
- au moins deux coupleurs d'ordre un (FOC) agencés dans le plan et configurés pour recevoir les faisceaux de diffraction d'ordre un et d'ordre moins un (FOD, MOD) et diffracter les faisceaux de diffraction d'ordre un et d'ordre moins un (FOD, MOD) dans le plan afin de former des faisceaux de diffraction d'ordre un et d'ordre moins un planaires ;
- un coupleur d'ordre zéro (ZOC) agencé dans le plan et configuré pour recevoir le faisceau de diffraction d'ordre zéro (ZOD) et pour diffracter le faisceau de diffraction d'ordre zéro (ZOD) dans le plan afin de former un faisceau de diffraction d'ordre zéro planaire ;
- un dispositif de combinaison d'ordre un et d'ordre moins un (FCD) configuré pour recevoir les faisceaux de diffraction d'ordre un et d'ordre moins un planaires et pour générer au moins un signal optique d'interférence d'ordre de diffraction un en utilisant les faisceaux de diffraction d'ordre un et d'ordre moins un planaires ;
- un dispositif de combinaison d'ordre zéro configuré pour recevoir le faisceau de diffraction d'ordre zéro planaire et une partie de référence du faisceau de source de lumière (LSB) et pour générer un signal optique d'interférence d'ordre de diffraction zéro en utilisant le faisceau de diffraction d'ordre zéro planaire et la partie de référence du faisceau de source de lumière (LSB) ;
- un capteur optique d'ordre un (FOS) agencé pour recevoir l'au moins un signal optique d'interférence d'ordre de diffraction un et pour générer un signal de sortie d'ordre de diffraction un en réponse à celui-ci ;
- un capteur optique d'ordre zéro (ZOS) agencé pour recevoir le signal optique d'interférence d'ordre de diffraction zéro et pour générer un signal de sortie d'ordre zéro en réponse à celui-ci.

2. Un système de mesure de position (PMS) comprenant un ou plusieurs capteurs de déplacement intégrés (IDS) selon la revendication 1 ; et un processeur (PRC) configuré pour dériver à partir du signal d'interférence d'ordre un des données de position de l'objet (OBJ) dans une première direction parallèle au plan de guide de lumière, et pour dériver à partir du signal d'interférence d'ordre zéro des données de position de l'objet (OBJ) dans une direction perpendiculaire au plan de guide de lumière.

3. Le système de mesure de position (PMS) selon la revendication 2, dans lequel le réseau cible (TGR) comprend une première partie de réseau cible et une deuxième partie de réseau cible, la première partie de réseau cible étant configurée pour diffracter le faisceau d'émission (EMB) afin de former le faisceau de diffraction d'ordre zéro (ZOD), le faisceau de diffraction d'ordre un et le faisceau de diffraction d'ordre moins un (FOD, MOD), la deuxième partie de réseau cible étant configurée pour diffracter le faisceau d'émission (EMB) afin de former le faisceau de diffraction d'ordre zéro (ZOD), un faisceau de diffraction d'ordre un supplémentaire et un faisceau de diffraction d'ordre moins un supplémentaire, et dans lequel le capteur de déplacement comprend en sus :
- au moins deux coupleurs supplémentaires (FFOC) agencés dans le plan de guide de lumière et configurés pour recevoir les faisceaux de diffraction d'ordre un supplémentaire et d'ordre moins un supplémentaire et diffracter les faisceaux de diffraction d'ordre un et d'ordre moins un supplémentaires dans le plan de guide de lumière afin de former des faisceaux de diffraction d'ordre un et d'ordre moins un planaires supplémentaires ;
- un dispositif de combinaison d'ordre un et d'ordre moins un supplémentaire (FFCD) configuré pour recevoir les faisceaux de diffraction d'ordre un et d'ordre moins un planaires supplémentaires et pour générer au moins un signal optique d'interférence d'ordre de diffraction un supplémentaire en utilisant les faisceaux de diffraction d'ordre un et d'ordre moins un planaires supplémentaires ;
- un capteur optique d'ordre un supplémentaire (FFOS) agencé pour recevoir l'au moins un signal optique d'interférence d'ordre de diffraction un supplémentaire et pour générer un signal de sortie d'ordre de diffraction un supplémentaire en réponse à celui-ci ; et
dans lequel le processeur (PRC) est configuré pour dériver à partir du signal d'interférence d'ordre un supplémentaire des données de position de l'objet (OBJ) dans une deuxième direction parallèle au plan de guide de lumière, et perpendiculaire à la première direction.

4. Le système de mesure de position (PMS) selon la revendication 3, dans lequel les première et deuxième parties de réseau cible sont agencées de manière substantiellement perpendiculaire l'une par rapport à l'autre.

5. Le système de mesure de position (PMS) selon l'une quelconque des revendications 2 à 4, dans lequel le processeur (PRC) est configuré pour dériver les données de position à partir d'une différence de phase dans le signal d'interférence respectif.

6. Le système de mesure de position (PMS) selon l'une quelconque des revendications 2 à 5, dans lequel le dispositif de combinaison d'ordre un et d'ordre moins un (FCD) est configuré pour faire interférer optiquement les faisceaux de diffraction d'ordre un et d'ordre moins un planaires afin de générer l'au moins un signal optique d'interférence d'ordre de diffraction un.

7. Le système de mesure de position (PMS) selon l'une quelconque des revendications 2 à 6, dans lequel le dispositif de combinaison d'ordre un et d'ordre moins un (FCD) est configuré pour faire interférer optiquement le faisceau de diffraction d'ordre un planaire avec une partie de référence supplémentaire du faisceau de source de lumière (LSB) et pour faire interférer le faisceau de diffraction d'ordre moins un (MOD) avec la partie de référence supplémentaire du faisceau de source de lumière (LSB) afin de générer deux signaux optiques d'interférence d'ordre de diffraction un, et dans lequel le capteur optique d'ordre un (FOS) est configuré pour recevoir les deux signaux optiques d'interférence d'ordre de diffraction un et pour générer deux signaux de sortie d'ordre de diffraction un en réponse à ceux-ci, le processeur (PRC) étant configuré pour dériver à partir des deux signaux d'interférence d'ordre un les données de position de l'objet (OBJ) dans la première direction parallèle au plan de guide de lumière.

8. Le système de mesure de position (PMS) selon l'une quelconque des revendications 2 à 7 comprenant en sus un séparateur configuré pour séparer par scission la partie de référence du faisceau de source de lumière, et lorsque dépendant de la revendication 7, la partie de référence supplémentaire du faisceau de source de lumière, du faisceau de source de lumière (LSB).

9. Le système de mesure de position (PMS) selon l'une quelconque des revendications 2 à 8, dans lequel le guide de lumière (LGD), le réseau d'émission (EGR), les coupleurs (ZOC, FOC, FFOC), les dispositifs de combinaison (FCD, FFCD) et les capteurs optiques (ZOS, FOS, FFOS) sont agencés sur un substrat semiconducteur.

10. Le système de mesure de position (PMS) selon l'une quelconque des revendications 2 à 9, dans lequel le réseau d'émission (EGR) est configuré de telle sorte que la direction d'émission est substantiellement perpendiculaire au plan de guide de lumière.

11. Le système de mesure de position (PMS) selon l'une quelconque des revendications 2 à 10, comprenant en sus la source de lumière configurée pour émettre le faisceau de source de lumière (LSB) vers le guide de lumière (LGD).

12. Le système de mesure de position (PMS) selon l'une quelconque des revendications 2 à 11, comprenant au moins deux capteurs de déplacement intégrés (IDS), dans lequel les réseaux cibles (TGR) sont agencés sur l'objet.

13. Le système de mesure de position (PMS) selon l'une quelconque des revendications 2 à 12, dans lequel le réseau d'émission (EGR) est le coupleur d'ordre zéro (ZOC).

14. Un appareil lithographique (LA) comprenant le système de mesure de position (PMS) selon l'une quelconque des revendications 2 à 13.

15. Un système de projection (PS) pour un système de lithographie optique comprenant le système de mesure de position (PMS) selon l'une quelconque des revendications 2 à 13.
